# EUROPEAN PATENT SPECIFICATION

(11) **EP 4 127 757 B1**
(45) Date of publication and mention of the grant of the patent: **31.12.2025**
(21) Application number: 21715312.1
(22) Date of filing: 26.03.2021
(51) Int. Cl.: G01R 33/561, G01R 33/56, G01R 33/54

(54) **MAGNETIC RESONANCE IMAGING METHOD AND DEVICE**
VERFAHREN UND VORRICHTUNG ZUR BILDERZEUGUNG MITTELS MAGNETISCHER RESONANZ
PROCÉDÉ ET DISPOSITIF D'IMAGERIE PAR RÉSONANCE MAGNÉTIQUE

(30) Priority: 30.03.2020 GB 202004588
(43) Date of publication of application: 08.02.2023
(73) Proprietor: Imperial College Innovations Limited, London SW7 2AZ (GB)
(72) Inventor: LALLY, Peter James, London NW6 7XS (GB)
(74) Representative: HGF
(86) International application number: PCT/GB2021/050751
(87) International publication number: WO 2021/198653

(56) References cited:
- WO-A1-2011/026923
- PETER J. LALLY ET AL: "Unbalanced SSFP for super-resolution in MRI", MAGNETIC RESONANCE IN MEDICINE, 17 November 2020 (2020-11-17), US, XP055758832, ISSN: 0740-3194, DOI: 10.1002/mrm.28593

## Description

### Field of the Invention

This invention relates to Magnetic Resonance Imaging (MRI) and in particular to a method and device which may provide high resolution images.

### Background to the Invention

Magnetic Resonance Imaging (MRI) is also sometimes called Nuclear Magnetic Resonance Imaging. During an MRI scan the subject to be scanned is placed in a static magnetic field, and the magnetic field causes nuclei within the subject to become magnetised with a net magnetisation aligned in parallel with the magnetic field. Often it is the protons of hydrogen atoms that are of interest, although the nuclei of atoms other than hydrogen can be studied using MRI techniques. The subject is then exposed to an electromagnetic pulse, typically a radiofrequency pulse, generated by a transmitter. The frequency and duration of the pulse is chosen to perturb the net magnetisation vector of the protons, in particular to tilt the net magnetisation vector perpendicularly to the static magnetic field. As the protons return to a lower energy state by relaxation, their precession creates a magnetic flux which can be detected by a receiver. From the magnetic flux, pixels which make up an image of the scanned subject can be determined.

Typically additional magnetic fields are applied to provide gradients within the overall magnetic field. These cause protons at different locations within the field to precess at different rates, so that a particular volume or slice of the subject can be selected and imaged.

As such, MRI is a non-invasive imaging modality which does not rely upon ionising radiation, and is often used in healthcare to generate images of tissues in the human body.

The signal produced by protons during an MRI scan is due to two relaxation processes. Firstly, the component of the net magnetisation vector of the protons parallel to the static magnetic field applied to the subject increases. The rate at which this occurs is governed by the constant T₁. Secondly, the component of the net magnetisation vector of the protons perpendicular to the static magnetic field applied to the subject decreases, in a process which is governed by the constant T₂. The value of T₁ and T₂ depends upon the characteristics of the materials that make up the subject to be scanned.

Often, radiofrequency pulses are applied many times in a sequence. The time resolved sequence of radiofrequency pulses and magnetic field gradients is therefore called a pulse sequence. In a sufficiently rapid pulse sequence, where the radiofrequency pulses are applied with an interval between pulses which is significantly less than T₂, the protons of the subject do not have sufficient time to relax to their thermal equilibrium state between pulses. Instead the protons reach a dynamic equilibrium known as the steady-state. One such pulse sequence is refocused Steady-State Free Precession (SSFP), which is a popular method of generating images with high signal-to-noise ratio (SNR) in a short acquisition time.

It is desirable to provide high-resolution images of subjects in an MRI scan. However, many methods of acquiring higher-resolution images require intense radiofrequency pulses and strong magnetic field gradients, which can lead to increased hardware performance requirements, low SNR efficiency, and an increased degree of heating in the subject of the scan.

WO 2011/026923 A1 discusses a method for obtaining a magnetic resonance image of an object with a given pulse sequence.

### Summary of the Invention

In pursuit of this aim, a presently preferred embodiment of the present invention provides a method for generating a magnetic resonance imaging, MRI, image of a subject, as defined in claim 1. The method comprises: applying a magnetic field B₀ to the subject; applying a sequence of radiofrequency electromagnetic pulses to the subject; applying further magnetic field gradients in addition to the magnetic field B₀, the magnetic field gradients comprising a plurality of first gradients and at least one second gradient, wherein the first gradients allow localisation of signals to a particular location in the subject by a combination of at least one of slice selection, phase encoding and frequency encoding, and wherein the first gradients are fully rewound in the interval between successive radiofrequency electromagnetic pulses, while the at least one second gradient has a non-zero time integral between successive radiofrequency electromagnetic pulses to provide a periodic signal modulation which depends on the off-resonance signal profile of the magnetisation in the subject; measuring signal echoes produced by the subject in response to a plurality of radiofrequency electromagnetic pulses and the first and second magnetic field gradients; acquiring image data of the particular location in the subject from the signal echoes, said image data corresponding to a series of images at a first spatial resolution with different periodic spatial variations in magnetisation resulting from the at least one second gradient; and combining the image data in order to produce at least one image of the subject at a second spatial resolution, the second spatial resolution being high than the first spatial resolution. The phase of at least one radiofrequency electromagnetic pulse in the sequence of radiofrequency electromagnetic pulses is different to another radiofrequency electromagnetic pulse in the sequence of radiofrequency electromagnetic pulses. The sequence of radiofrequency electromagnetic pulses and plurality of first magnetic field gradients is a steady state free precession pulse sequence. The periodic spatial variations in magnetisation are generated in the steady-state or a pseudo steady-state, and contain information about spatial frequencies above the Nyquist frequency.

In this way, the method provides an image of the subject wherein only certain specific locations within the subject contribute to the signal echoes. The first gradients allow localisation of signals to a particular location in the subject, by a combination of at least one of slice selection, phase encoding and frequency encoding. The second gradient provides a periodic signal modulation which depends on the off-resonance signal profile of the protons in the subject. The periodic spatial variations in magnetisation are generated in the steady-state, and contain information about spatial frequencies above the Nyquist frequency. A series of images with nominal spatial resolution are therefore acquired, each with different periodic variations in magnetisation. These can be combined to generate an image with spatial resolution higher than the nominal spatial resolution.

A further embodiment of the present invention provides an MRI device as defined in claim 6, which comprises a controller, the controller being configured to control the MRI device to: apply a magnetic field B₀ to a subject; apply a sequence of radiofrequency electromagnetic pulses to the subject; apply further magnetic field gradients in addition to the magnetic field B₀, the magnetic field gradients comprising a plurality of first gradients and at least one second gradient, wherein the first gradients allow localisation of signals to a particular location in the subject by a combination of at least one of slice selection, phase encoding and frequency encoding, and wherein the first gradients are fully rewound in the interval between successive radiofrequency electromagnetic pulses, while the at least one second gradient has a non-zero time integral between successive radiofrequency electromagnetic pulses to provide a periodic signal modulation which depends on the off-resonance signal profile of the magnetisation in the subject; and measure signal echoes produced by the subject in response to a plurality of the radiofrequency electromagnetic pulses and the first and second magnetic field gradients. The controller is further configured to: acquire image data of the particular location in the subject from the signal echoes, said image data corresponding to a series of images at a first spatial resolution with different periodic spatial variations in magnetisation resulting from the at least one second gradient; and combine the image data in order to produce at least one image of the subject at a second spatial resolution, the second spatial resolution being higher than the first spatial resolution. The phase of at least one radiofrequency electromagnetic pulse in the sequence of radiofrequency electromagnetic pulses is different to another radiofrequency electromagnetic pulse in the sequence of radiofrequency electromagnetic pulses. The sequence of radiofrequency electromagnetic pulses and plurality of first magnetic field gradients is a steady state free precession pulse sequence. The periodic spatial variations in magnetisation are generated in the steady-state or a pseudo steady-state, and contain information about spatial frequencies above the Nyquist frequency.

When a linear magnetic field gradient is applied along a given axis, the linear variation in precession frequency results in a linear phase dispersion between protons along that axis. Since first gradients have zero integral between successive electromagnetic pulses, these do not produce any accumulation in phase dispersion in a static object. The second gradient has non-zero integral, and so produces an accumulating phase dispersion throughout the application of successive electromagnetic pulses. The time integral of the second gradient between successive electromagnetic pulses is proportional to the slope of this linear phase dispersion, and determines the periodicity of the modulation pattern in space, Δx, in the steady-state. This is related to the gradient-time integral as follows: ∫G(t)dt = 2π/γΔx, where G is the gradient strength and γ is the gyromagnetic ratio. The minimum periodicity which can be resolved is where Δx is equal to the nominal voxel spacing along that axis, so that the pattern is repeated once in each voxel.

The MRI device typically comprises a magnetic array suitable for creating the magnetic field B₀ and the magnetic field gradients. The MRI device typically comprises a transmitter for transmitting the electromagnetic pulses. The MRI device typically comprises a receiver for measuring signal echoes produced by the object in response to the electromagnetic pulses.

The images may be merged on a voxel by voxel basis in the image domain. The image data may also be combined in the frequency domain. The data may be combined using artificial intelligence.

The first gradients are fully rewound so that their gradient-time integral is zero between successive electromagnetic pulses.

The electromagnetic pulses discussed in the rest of this description are radio frequency pulses. The sequence of electromagnetic pulses and magnetic field gradients is a steady state free precession (SSFP) pulse sequence.

The method may be repeated to get images which are separated in space or in time. In other words, images of other sections of the subject may be acquired by adjusting the first gradients, second gradients, or electromagnetic pulse phases in order to provide an image of a desired location within the subject, and imaging of a same section of the subject may be repeated to provide multiple images of the same section separated by the passage of time.

It may be that the sequence of electromagnetic pulses comprises at least a first set of electromagnetic pulses, wherein a first pulse of the first set has a first phase φ₁, and each subsequent pulse of the first set has a phase which is incremented by a first interval. This first interval may be fixed, so that the phase of subsequent electromagnetic pulses in a set increases linearly.

By incrementing the phase of the pulses linearly between successive excitations, a translation of signal modulation by a fraction of its periodicity is caused in the resultant image. This process may be repeated to produce images with different fractional translations of the signal modulation, produced by different fixed phase increments. These images may then be interleaved voxel-by-voxel, before a one-dimensional deconvolution may be performed using the estimated off-resonance profile.

The sequence of electromagnetic pulses may comprise a second set of electromagnetic pulses, which may occur before or after the first set of electromagnetic pulses, wherein a first pulse of the second set has a second phase φ₂, and each subsequent pulse in the second set has a phase which is incremented by a second interval which is different to the first interval. The sequence of electromagnetic pulses may comprise a third set of electromagnetic pulses. The sequence of electromagnetic pulses may comprise still further sets of electromagnetic pulses. The sequence of electromagnetic pulses may comprise as many sets of electromagnetic pulses as are necessary.

The first phase may be the same as the second phase, such that φ₁ = φ₂. Images derived from the two sets of electromagnetic pulses may be combined to produce a single image. More than two images may be combined to create a single image
Where the sequence of electromagnetic pulses comprises at least a first set of electromagnetic pulses, and a first pulse of the first set has a first phase φ₁, it may be that each subsequent pulse of the first set has a phase which is incremented by a quadratically increasing interval.

Incrementing the phase of successive electromagnetic pulses quadratically may produce a pseudo-steady-state, in which the magnetisation profile is fractionally shifted between successive electromagnetic pulses. This may be continued to produce at least two images with a first spatial resolution. These images may be reordered and combined to a single image with a spatial resolution greater than the first spatial resolution.

It may be that the image data from more than one signal echo is measured in the interval between subsequent pulses in the sequence of electromagnetic pulses. These data may be fit to a signal model to estimate quantitative properties of the object, such as T₁, T₂ or nuclear diffusion characteristics. The data from several echoes in one interval may be Fourier transformed to give an estimate of the off-resonance profile.

It may be that the steady-state or pseudo-steady-state is interrupted by at least one other magnetic field gradient or electromagnetic pulse, such as an inversion pulse, so that the signals are weighted by their quantitative properties. The recovery to the steady-state or pseudo-steady-state condition may be fit to a signal model to estimate quantitative properties of the object.

The second gradient may have any shape which produces a non-zero time integral along any axis between successive electromagnetic pulses.

It may be that the first gradients describe a non-Cartesian acquisition. This non-Cartesian acquisition may have no fixed axis for at least one of frequency encoding, phase encoding, or slice selection. It may be that the first or second gradients generate non-linear magnetic field gradients.

It may be that the merged image is deconvolved by a spatial profile. It may be that the image deconvolution is performed in the frequency domain. It may be that the deconvolution is informed by an estimate of the inhomogeneity of the magnetic field B₁ which is produced by the electromagnetic pulses. It may be that this B₁ estimate is derived from the data itself. It may be that the merging of the image data is informed by an estimate of the inhomogeneity of the static magnetic field, B₀. It may be that this B₀ estimate is derived from the data itself. It may be that the merging of the image data is informed by an estimate of the motion of the subject during the acquisition. It may be that this motion estimate is derived from the data itself.

Advantages of these embodiments are set out hereafter, and further details and features of each of these embodiments are defined in the accompanying dependent claims and elsewhere in the following detailed description.

### Brief Description of the Drawings

Various aspects of the teachings of the present invention, and arrangements embodying those teachings, will hereafter be described by way of illustrative example with reference to the accompanying drawings, in which:
Figure 1 is an example of a Magnetic Resonance Imaging device according to the invention;
Figures 2 and 3 illustrates the magnetic field gradients that are applied by the MRI device; wherein only figure 3 illustrates an image acquisition according to the present invention;
Figure 4 illustrates off resonance frequency profiles for a group of protons in the MRI device;
Figure 5 illustrates the fractional shift in the off resonance frequency profile when applying sets of electromagnetic pulses with different linear phase increments;
Figures 6 and 7 are example images from the MRI device. Figure 6 illustrates the method through simulations while Figure 7 is an example using real acquired data.

### Detailed Description of Preferred Embodiments

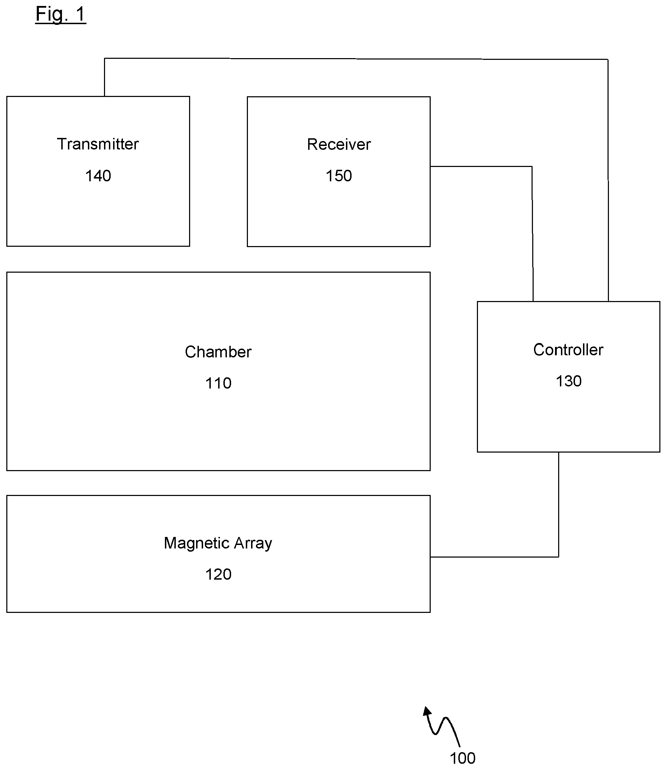

Figure 1 is a block diagram of a Magnetic Resonance Imaging (MRI) device 100 according to the invention. The MRI device 100 comprises a chamber 110 which holds the subject which is to be scanned, and which is surrounded by a magnetic array 120 which is arranged to induce magnetic fields in the chamber 110. The functioning of the magnetic array 120 is controlled by a controller 130. The controller 130 also controls a transmitter 140, which is arranged to broadcast radiofrequency pulses into the chamber 110. A receiver 150 is arranged to detect electromagnetic signals from the subject in the chamber 110, and provide these signals to the controller 130.

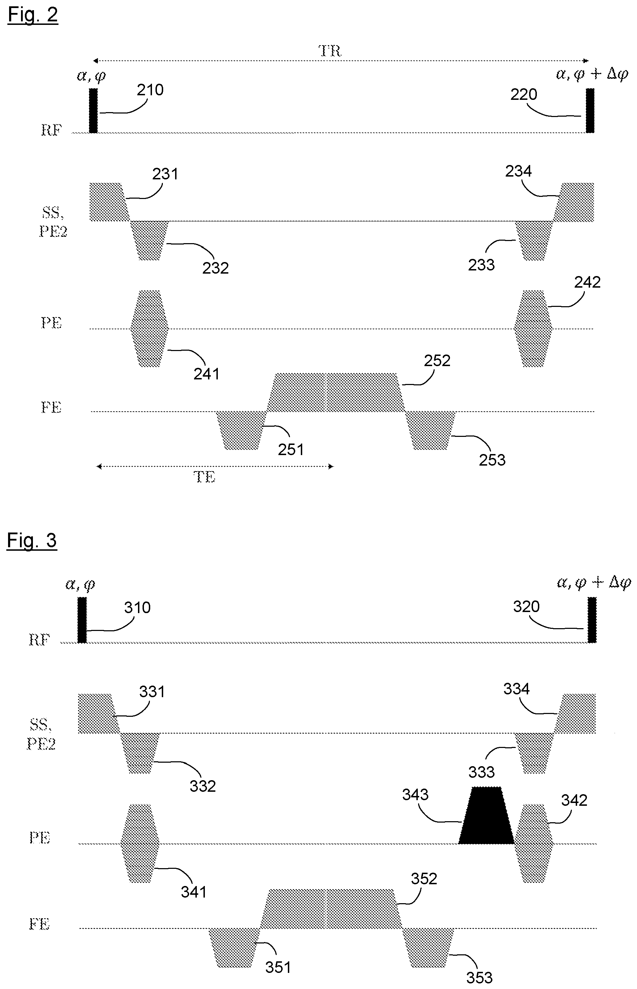

Figure 2 is a diagram illustrating the operation of the MRI device 100 when used for image acquisition using a refocussed Steady State Free Precession (SSFP) pulse sequence. Figure 2 illustrates the pulses and magnetic fields applied during one repetition time, TR.

In refocussed SSFP sequences a radiofrequency pulse 210, 220 is repeatedly applied, alongside magnetic field gradients which are fully rewound during the repetition time, TR. This means that the time integral of the magnetic field gradients applied to the subject during the interval between two radiofrequency pulses 210, 220 is zero.

At the beginning of a repetition time TR, a first radiofrequency pulse 210 is applied to the subject. The first radiofrequency pulse 210 has an intensity α and a phase φ. The first radiofrequency pulse 210 causes excitation of nuclei in the subject to be scanned, causing the net magnetisation vector of the nuclei in the subject to rotate into the transverse plane by a flip angle α. The nuclei may be those of hydrogen atoms. The magnetisation then precesses about the main magnetic field, B₀, at a rate proportional to the local off-resonance frequency. The magnetisation of the subject relaxes with time constants T₁ and T₂.

Figure 2 illustrates the magnetic field gradients that are applied during the repetition time as part of slice selection (SS), phase encoding (PE) and frequency encoding (FE). The magnetic field gradients applied for slice selection 231, 232, 233, 234 create a corresponding gradient in precession frequencies of the subject, so that a given slice of the subject can be selected for scanning. In particular, the magnetic field gradients applied for slice selection 231, 232, 233, 234 can be varied in intensity to select the desired slice width. Slice selection therefore allows for localisation along a first axis within the subject.

The magnetic field gradients applied for phase encoding (PE) 241, 242 cause phase dispersion in the precession of the nuclei. The magnetic field gradients applied for phase encoding 241, 242 may be also varied in intensity in order to localise along a second axis within the subject which is perpendicular to the first axis. In some embodiments, phase encoding is used on two axes, the second phase encoding PE2 complementing or replacing slice selection.

The magnetic field gradients applied for frequency encoding (FE) 251, 252, 253 cause a frequency dispersion in the precession of nuclei along a third axis which is perpendicular to the first axis and the second axis, in order to localise along this third axis within the subject.

As such, when signals are detected by the receiver 150, signals related to areas within the slice can be identified by their unique combination of frequency and phase encoding, and used to generate pixels for use in a resulting image of the slice, usually by the application of a Fourier transformation.

Signals are detected during each TR, centred at the echo time (TE) which is the time between the application of a radiofrequency pulse and the centre of the signal which is induced in the receiver 150. **TE** is typically equal to half of TR.

Figure 3 is a diagram illustrating the operation of the MRI device 100 when used for image acquisition according to the present invention. In the operation, a similar data acquisition is employed to that used for refocussed SSFP acquisitions. In particular, a plurality of radiofrequency pulses 310, 320 are applied to the subject to be scanned while it is in the chamber 110. In each TR, magnetic field gradients 331, 332, 333, 334, 341, 342, 351, 352, 353 are applied to the subject in order to provide slice selection, phase encoding and frequency encoding. An additional magnetic field gradient is applied with a non-zero time integral in a specific direction. In the example shown in Figure 3, the additional magnetic field gradient 343 is applied in the same direction as the phase encoding. The additional magnetic field gradient 343 is applied in each TR.

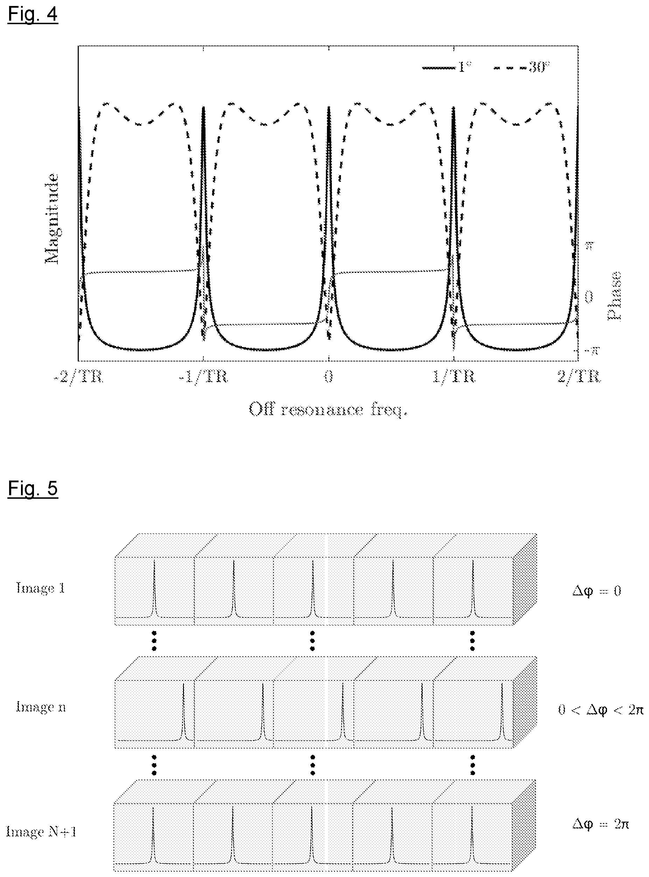

For a given material in a subject to be scanned, the steady-state magnetisation is strongly dependent on the off-resonance frequency Δf, which is the deviation from the frequency produced by an ideal homogeneous magnetic field. Figure 4 illustrates the dependence of signal magnitude on off resonance frequency. In the limit of low flip angles, such as α=1°, the magnitude of the off-resonance profile approximates a damped comb function with a period of 1/TR. Following a radiofrequency pulse with a phase of φ, the next radiofrequency pulse has a phase of φ+Δφ. By linearly incrementing the phase of successive radiofrequency excitation pulses, the off-resonance profile is offset along the frequency dimension by Δφ/(2πTR) in the final image.

The off-resonance profile and the additional magnetic field gradient 343 result in a periodic modulation of the spatial magnetisation along the direction of the additional magnetic field gradient, wherein the position of the peaks in the periodic modulation depend upon the value of the phase increment of the radiofrequency pulse series. As such, when the phase of each radiofrequency pulse in a set is incremented by Δφ, the position of the peaks in the periodic modulation are shifted slightly with respect to the subject.

Figure 5 illustrates the migration of peaks in the periodic modulation as the linear phase increment is changed between radiofrequency pulse sets, from Δφ=0 to Δφ=2π. The images which are derived from each set therefore correspond to different fractional shifts of this periodic modulation. The images from each set can then be merged to generate a super-resolution image.

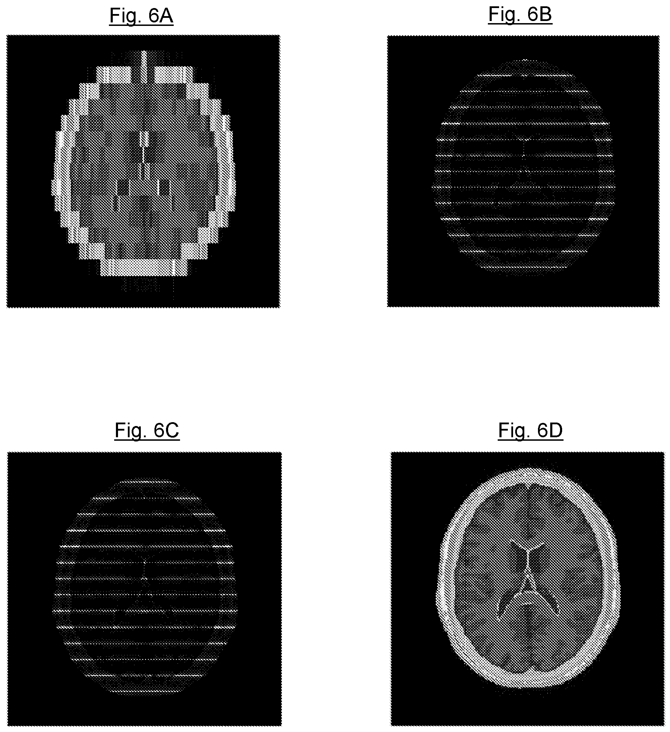

Figures 6A, 6B, 6C and 6D show an example application of the approach illustrated in Figure 3, wherein the MRI device 100 is used in creating a cross-sectional scan of a brain. One of the sets of image data is shown in Fig 6A, and the underlying magnetisation profile in Fig 6A is shown in Fig 6B. If the phase increment between successive radiofrequency excitations is changed, the modulation pattern shifts in the resultant image as shown in Fig 6C, thus containing different information about high-spatial frequencies. Seventeen sets of image data were simulated with different phase increments, including the image shown in Fig 6A, and merged to generate the super-resolution image shown in Fig 6D.

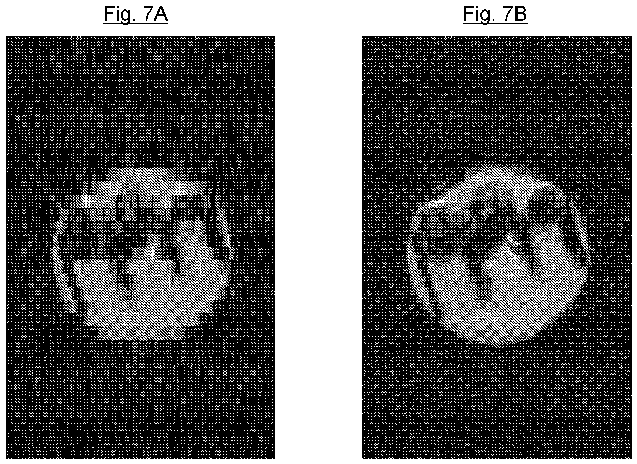

Fig 7A shows a single 2D SSFP acquisition with a nominal spatial resolution of 0.3x1.8mm, using a flip angle α=0.4° and including an additional magnetic field gradient as illustrated in Fig 3, such that the periodicity of the modulation pattern is equal to 1.8mm in the up-down direction. By interleaving six of these images voxel by voxel, where the spatial modulation pattern has been shifted in six equidistant steps, super-resolution is achieved in one dimension and a 0.3x0.3mm image is produced, as shown in Fig 7B.

The use of low flip angles allows for a simple deconvolution operation when merging the images, since most of the signal is generated within the narrow peak in the off-resonance profile, as can be seen for example in Figure 6B, and there is minimal signal cancellation from magnetisation elsewhere. As a result, the voxel interleaving and deconvolution operations work effectively using only the magnitude of the complex images. However, the approach could equally be used at higher flip angles if combined with a deconvolution operation which accounts for the complex integral of the broader off-resonance profiles, which can be seen in Figure 2. This may further increase the SNR efficiency of the proposed super-resolution approach. However, the use of low radiofrequency pulse flip angles can help to minimise tissue heating.

Although in Fig 3 the additional magnetic field gradient is positive in the phase encode direction, it can take any shape provided it has the required non-zero time integral, and it can be equally applied in any direction. For example, the additional magnetic field gradient may be applied in the slice selection direction or the second phase encoding direction, and the additional magnetic field gradient may be applied in the frequency encoding direction.

## Claims

1. A method for generating a magnetic resonance imaging, MRI, image of a subject, the method comprising:
applying a magnetic field B₀ to the subject;
applying a sequence of radiofrequency electromagnetic pulses (310, 320) to the subject;
applying further magnetic field gradients in addition to the magnetic field B₀, the magnetic field gradients comprising a plurality of first gradients (331, 332, 333, 334, 341, 342, 351, 352, 353) and at least one second gradient (343), wherein the first gradients allow localisation of signals to a particular location in the subject by a combination of at least one of slice selection, phase encoding and frequency encoding, and wherein the first gradients are fully rewound in the interval between successive radiofrequency electromagnetic pulses, while the at least one second gradient has a non-zero time integral between successive radiofrequency electromagnetic pulses to provide a periodic signal modulation which depends on the off-resonance signal profile of the magnetisation in the subject;
measuring signal echoes produced by the subject in response to a plurality of the electromagnetic pulses and the first and second magnetic field gradients;
acquiring image data of the particular location in the subject from the signal echoes, said image data corresponding to a series of images at a first spatial resolution with different periodic spatial variations in magnetisation resulting from the at least one second gradient; and
combining the image data in order to produce at least one image of the subject at a second spatial resolution, the second spatial resolution being higher than the first spatial resolution,
wherein the phase of at least one radiofrequency electromagnetic pulse in the sequence of radiofrequency electromagnetic pulses is different to another radiofrequency electromagnetic pulse in the sequence of radiofrequency electromagnetic pulses,
wherein the sequence of radiofrequency electromagnetic pulses and plurality of first magnetic field gradients is a steady state free precession pulse sequence,
wherein the periodic spatial variations in magnetisation are generated in the steady-state or a pseudo steady-state, and contain information about spatial frequencies above the Nyquist frequency.

2. A method for generating a magnetic resonance image of a subject according to claim 1, wherein the sequence of radiofrequency electromagnetic pulses comprises at least a first set of radiofrequency electromagnetic pulses, wherein a first pulse of the first set has a first phase φ₁, and each subsequent pulse of the first set has a phase which is incremented by a first interval.

3. A method for generating a magnetic resonance image of a subject according to claim 2, wherein the sequence of radiofrequency electromagnetic pulses comprises a second set of radiofrequency electromagnetic pulses, wherein a first pulse of the second set has a second phase φ₂, and each subsequent pulse in the second set has a phase which is incremented by a second interval which is different to the first interval.

4. A method for generating a magnetic resonance image of a subject according to claim 1, wherein the sequence of radiofrequency electromagnetic pulses comprises at least a first set of radiofrequency electromagnetic pulses, wherein a first pulse of the first set has a first phase φ₁, and each subsequent pulse of the first set has a phase which is incremented by a quadratically increasing interval.

5. A method for generating a magnetic resonance image of a subject according to any preceding claim, wherein the image data from more than one signal echo is measured in the interval between subsequent pulses in the sequence of electromagnetic pulses.

6. A magnetic resonance imaging, MRI, device (100) which comprises a controller (130), the controller being configured to control the MRI device to:
apply a magnetic field B₀ to a subject;
apply a sequence of radiofrequency electromagnetic pulses to the subject;
apply further magnetic field gradients in addition to the magnetic field B₀, the magnetic field gradients comprising a plurality of first gradients and at least one second gradient, wherein the first gradients allow localisation of signals to a particular location in the subject by a combination of at least one of slice selection, phase encoding and frequency encoding, and wherein the first gradients are fully rewound in the interval between successive radiofrequency electromagnetic pulses, while the at least one second gradient has a non-zero time integral between successive radiofrequency electromagnetic pulses to provide a periodic signal modulation which depends on the off-resonance signal profile of the magnetisation in the subject; and
measure signal echoes produced by the subject in response to a plurality of the radiofrequency electromagnetic pulses and the first and second magnetic field gradients,
the controller being further configured to:
acquire image data of the particular location in the subject from the signal echoes, said image data corresponding to a series of images at a first spatial resolution with different periodic spatial variations in magnetisation resulting from the at least one second gradient; and
combine the image data in order to produce at least one image of the subject at a second spatial resolution, the second spatial resolution being higher than the first spatial resolution,
wherein the phase of at least one radiofrequency electromagnetic pulse in the sequence of radiofrequency electromagnetic pulses is different to another radiofrequency electromagnetic pulse in the sequence of radiofrequency electromagnetic pulses,
wherein the sequence of radiofrequency electromagnetic pulses and plurality of first magnetic field gradients is a steady state free precession pulse sequence,
wherein the periodic spatial variations in magnetisation are generated in the steady-state or a pseudo steady-state, and contain information about spatial frequencies above the Nyquist frequency.

7. An MRI device (100) according to claim 6, wherein the sequence of radiofrequency electromagnetic pulses comprises at least a first set of radiofrequency electromagnetic pulses, wherein a first pulse of the first set has a first phase φ₁, and each subsequent pulse of the first set has a phase which is incremented by a first interval.

8. An MRI device (100) according to claim 7, wherein the sequence of radiofrequency electromagnetic pulses comprises a second set of radiofrequency electromagnetic pulses, wherein a first pulse of the second set has a second phase φ₂, and each subsequent pulse in the second set has a phase which is incremented by a second interval which is different to the first interval.

9. An MRI device (100) according to claim 8, wherein the sequence of radiofrequency electromagnetic pulses comprises at least a first set of radiofrequency electromagnetic pulses, wherein a first pulse of the first set has a first phase φ₁, and each subsequent pulse of the first set has a phase which is incremented by a quadratically increasing interval.

10. An MRI device (100) according to any of claims 6 to 9, wherein the image data from more than one signal echo is measured in the interval between subsequent pulses in the sequence of radiofrequency electromagnetic pulses.

## Patentansprüche

1. Verfahren zur Erzeugung eines Magnetresonanztomografie-, MRT-, Bilds eines Subjekts, wobei das Verfahren Folgendes umfasst:
Anwenden eines Magnetfelds B₀ auf das Subjekt;
Anwenden einer Sequenz aus hochfrequenten elektromagnetischen Impulsen (310, 320) auf das Subjekt;
Anwenden weiterer Magnetfeldgradienten zusätzlich zu dem Magnetfeld B₀, wobei die Magnetfeldgradienten eine Vielzahl von ersten Gradienten (331, 332, 333, 334, 341, 342, 351, 352, 353) und mindestens einen zweiten Gradienten (343) umfassen, wobei die ersten Gradienten eine Lokalisierung von Signalen an einer bestimmten Stelle in dem Subjekt durch eine Kombination von mindestens einer von Scheibenselektion, Phasenkodierung und Frequenzkodierung erlauben und wobei die ersten Gradienten in dem Intervall zwischen aufeinanderfolgenden hochfrequenten elektromagnetischen Impulsen vollständig zurückgedreht werden, während der mindestens eine zweite Gradient ein Zeitintegral von nicht Null zwischen aufeinanderfolgenden hochfrequenten elektromagnetischen Impulsen aufweist, um eine periodische Signalmodulation bereitzustellen, die von dem Off-Resonanz-Signalprofil der Magnetisierung in dem Subjekt abhängt;
Messen von Signalechos, die von dem Subjekt als Reaktion auf eine Vielzahl der elektromagnetischen Impulse und die ersten und zweiten Magnetfeldgradienten produziert werden;
Erfassen von Bilddaten der bestimmten Stelle in dem Subjekt aus den Signalechos, wobei die Bilddaten einer Reihe von Bildern bei einer ersten räumlichen Auflösung mit unterschiedlichen periodischen räumlichen Variationen der Magnetisierung entsprechen, die aus dem mindestens einen zweiten Gradienten resultieren; und
Kombinieren der Bilddaten, um mindestens ein Bild des Subjekts bei einer zweiten räumlichen Auflösung zu produzieren, wobei die zweite räumliche Auflösung höher als die erste räumliche Auflösung ist,
wobei sich die Phase mindestens eines hochfrequenten elektromagnetischen Impulses in der Sequenz aus hochfrequenten elektromagnetischen Impulsen von einem anderen hochfrequenten elektromagnetischen Impuls in der Sequenz aus hochfrequenten elektromagnetischen Impulsen unterscheidet,
wobei die Sequenz aus hochfrequenten elektromagnetischen Impulsen und die Vielzahl von ersten Magnetfeldgradienten eine freie Präzessionsimpulssequenz im stabilen Zustand ist,
wobei die periodischen räumlichen Variationen der Magnetisierung in dem stabilen Zustand oder einem pseudostabilen Zustand erzeugt werden und Informationen über räumliche Frequenzen oberhalb der Nyquist-Frequenz enthalten.

2. Verfahren zur Erzeugung eines Magnetresonanzbilds eines Subjekts nach Anspruch 1, wobei die Sequenz aus hochfrequenten elektromagnetischen Impulsen mindestens einen ersten Satz von hochfrequenten elektromagnetischen Impulsen umfasst, wobei ein erster Impuls des ersten Satzes eine erste Phase φ₁ aufweist und jeder nachfolgende Impuls des ersten Satzes eine Phase aufweist, die um ein erstes Intervall inkrementiert wird.

3. Verfahren zur Erzeugung eines Magnetresonanzbilds eines Subjekts nach Anspruch 2, wobei die Sequenz aus hochfrequenten elektromagnetischen Impulsen einen zweiten Satz von hochfrequenten elektromagnetischen Impulsen umfasst, wobei ein erster Impuls des zweiten Satzes eine zweite Phase φ₂ aufweist und jeder nachfolgende Impuls in dem zweiten Satz eine Phase aufweist, die um ein zweites Intervall, das sich von dem ersten Intervall unterscheidet, inkrementiert wird.

4. Verfahren zur Erzeugung eines Magnetresonanzbilds eines Subjekts nach Anspruch 1, wobei die Sequenz aus hochfrequenten elektromagnetischen Impulsen mindestens einen ersten Satz von hochfrequenten elektromagnetischen Impulsen umfasst, wobei ein erster Impuls des ersten Satzes eine erste Phase φ₁ aufweist und jeder nachfolgende Impuls des ersten Satzes eine Phase aufweist, die um ein quadratisch zunehmendes Intervall inkrementiert wird.

5. Verfahren zur Erzeugung eines Magnetresonanzbilds eines Subjekts nach einem vorhergehenden Anspruch, wobei die Bilddaten aus mehr als einem Signalecho in dem Intervall zwischen nachfolgenden Impulsen in der Sequenz aus elektromagnetischen Impulsen gemessen werden.

6. Magnetresonanztomografie-, MRT-, Vorrichtung (100), die eine Steuerung (130) umfasst, wobei die Steuerung dazu konfiguriert ist, die MRT-Vorrichtung zu Folgendem zu steuern:
Anwenden eines Magnetfelds B₀ auf ein Subjekt;
Anwenden einer Sequenz aus hochfrequenten elektromagnetischen Impulsen auf das Subjekt;
Anwenden weiterer Magnetfeldgradienten zusätzlich zu dem Magnetfeld B₀, wobei die Magnetfeldgradienten eine Vielzahl von ersten Gradienten und mindestens einen zweiten Gradienten umfassen, wobei die ersten Gradienten eine Lokalisierung von Signalen an einer bestimmten Stelle in dem Subjekt durch eine Kombination von mindestens einer von Scheibenselektion, Phasenkodierung und Frequenzkodierung erlauben und wobei die ersten Gradienten in dem Intervall zwischen aufeinanderfolgenden hochfrequenten elektromagnetischen Impulsen vollständig zurückgedreht werden, während der mindestens eine zweite Gradient ein Zeitintegral von nicht Null zwischen aufeinanderfolgenden hochfrequenten elektromagnetischen Impulsen aufweist, um eine periodische Signalmodulation bereitzustellen, die von dem Off-Resonanz-Signalprofil der Magnetisierung in dem Subjekt abhängt; und
Messen von Signalechos, die von dem Subjekt als Reaktion auf eine Vielzahl der hochfrequenten elektromagnetischen Impulse und die ersten und zweiten Magnetfeldgradienten produziert werden,
wobei die Steuerung ferner konfiguriert ist zum:
Erfassen von Bilddaten der bestimmten Stelle in dem Subjekt aus den Signalechos, wobei die Bilddaten einer Reihe von Bildern bei einer ersten räumlichen Auflösung mit unterschiedlichen periodischen räumlichen Variationen der Magnetisierung entsprechen, die aus dem mindestens einen zweiten Gradienten resultieren; und
Kombinieren der Bilddaten, um mindestens ein Bild des Subjekts bei einer zweiten räumlichen Auflösung zu produzieren, wobei die zweite räumliche Auflösung höher als die erste räumliche Auflösung ist,
wobei sich die Phase mindestens eines hochfrequenten elektromagnetischen Impulses in der Sequenz aus hochfrequenten elektromagnetischen Impulsen von einem anderen hochfrequenten elektromagnetischen Impuls in der Sequenz aus hochfrequenten elektromagnetischen Impulsen unterscheidet,
wobei die Sequenz aus hochfrequenten elektromagnetischen Impulsen und die Vielzahl von ersten Magnetfeldgradienten eine freie Präzessionsimpulssequenz im stabilen Zustand ist,
wobei die periodischen räumlichen Variationen der Magnetisierung in dem stabilen Zustand oder einem pseudostabilen Zustand erzeugt werden und Informationen über räumliche Frequenzen oberhalb der Nyquist-Frequenz enthalten.

7. MRT-Vorrichtung (100) nach Anspruch 6, wobei die Sequenz aus hochfrequenten elektromagnetischen Impulsen mindestens einen ersten Satz von hochfrequenten elektromagnetischen Impulsen umfasst, wobei ein erster Impuls des ersten Satzes eine erste Phase φ₁ aufweist und jeder nachfolgende Impuls des ersten Satzes eine Phase aufweist, die um ein erstes Intervall inkrementiert wird.

8. MRT-Vorrichtung (100) nach Anspruch 7, wobei die Sequenz aus hochfrequenten elektromagnetischen Impulsen einen zweiten Satz von hochfrequenten elektromagnetischen Impulsen umfasst, wobei ein erster Impuls des zweiten Satzes eine zweite Phase φ₂ aufweist und jeder nachfolgende Impuls in dem zweiten Satz eine Phase aufweist, die um ein zweites Intervall, das sich von dem ersten Intervall unterscheidet, inkrementiert wird.

9. MRT-Vorrichtung (100) nach Anspruch 8, wobei die Sequenz aus hochfrequenten elektromagnetischen Impulsen mindestens einen ersten Satz von hochfrequenten elektromagnetischen Impulsen umfasst, wobei ein erster Impuls des ersten Satzes eine erste Phase φ₁ aufweist und jeder nachfolgende Impuls des ersten Satzes eine Phase aufweist, die um ein quadratisch ansteigendes Intervall inkrementiert wird.

10. MRT-Vorrichtung (100) nach einem der Ansprüche 6 bis 9, wobei die Bilddaten aus mehr als einem Signalecho in dem Intervall zwischen aufeinanderfolgenden Impulsen in der Sequenz aus hochfrequenten elektromagnetischen Impulsen gemessen werden.

## Revendications

1. Procédé permettant la génération d'une image par imagerie par résonance magnétique, IRM, d'un sujet, le procédé comprenant :
l'application d'un champ magnétique B₀ sur le sujet ;
l'application d'une séquence d'impulsions électromagnétiques de radiofréquence (310, 320) sur le sujet ;
l'application de gradients supplémentaires de champ magnétique en plus du champ magnétique B₀, les gradients de champ magnétique comprenant une pluralité de premiers gradients (331, 332, 333, 334, 341, 342, 351, 352, 353) et au moins un second gradient (343), lesdits premiers gradients permettant la localisation de signaux à un emplacement particulier chez le sujet par une combinaison d'au moins une opération parmi la sélection de tranche, le codage de phase et le codage de fréquence, et lesdits premiers gradients étant complètement rembobinés dans l'intervalle entre les impulsions électromagnétiques radiofréquences successives, tandis que ledit au moins un second gradient présentant une intégrale temporelle non nulle entre les impulsions électromagnétiques radiofréquences successives pour assurer une modulation de signal périodique qui dépend du profil de signal hors résonance de l'aimantation chez le sujet ;
la mesure des échos de signal produits par le sujet en réponse à une pluralité d'impulsions électromagnétiques et aux premier et second gradients de champ magnétique ;
l'acquisition de données d'images de l'emplacement particulier chez le sujet à partir des échos de signal, lesdites données d'images correspondant à une série d'images à une première résolution spatiale avec différentes variations spatiales périodiques de l'aimantation résultant dudit au moins un second gradient ; et
la combinaison des données d'images afin de produire au moins une image du sujet à une seconde résolution spatiale, la seconde résolution spatiale étant supérieure à la première résolution spatiale,
ladite phase d'au moins une impulsion électromagnétique radiofréquence dans la séquence d'impulsions électromagnétiques radiofréquences étant différente d'une autre impulsion électromagnétique radiofréquence dans la séquence d'impulsions électromagnétiques radiofréquences,
ladite séquence d'impulsions électromagnétiques radiofréquences et de pluralité de premiers gradients de champ magnétique étant une séquence d'impulsions de précession libre d'état stationnaire,
lesdites variations spatiales périodiques de magnétisation étant générées dans l'état stationnaire ou dans un état pseudo-stationnaire, et contenant des informations sur les fréquences spatiales au-dessus de la fréquence de Nyquist.

2. Procédé permettant la génération d'une image par résonance magnétique d'un sujet selon la revendication 1, ladite séquence d'impulsions électromagnétiques radiofréquences comprenant au moins un premier ensemble d'impulsions électromagnétiques radiofréquences, une première impulsion du premier ensemble possédant une première phase φ₁, et chaque impulsion suivante du premier ensemble présentant une phase qui est incrémentée d'un premier intervalle.

3. Procédé permettant la génération d'une image par résonance magnétique d'un sujet selon la revendication 2, ladite séquence d'impulsions électromagnétiques radiofréquences comprenant un second ensemble d'impulsions électromagnétiques radiofréquences, une première impulsion du second ensemble possédant une seconde phase φ₂, et chaque impulsion suivante dans le second ensemble possédant une phase qui est incrémentée d'un second intervalle qui est différent du premier intervalle.

4. Procédé permettant la génération d'une image par résonance magnétique d'un sujet selon la revendication 1, ladite séquence d'impulsions électromagnétiques radiofréquences comprenant au moins un premier ensemble d'impulsions électromagnétiques radiofréquences, une première impulsion du premier ensemble possédant une première phase φ₁, et chaque impulsion suivante du premier ensemble possédant une phase qui est incrémentée d'un intervalle d'augmentation quadratique.

5. Procédé permettant la génération d'une image par résonance magnétique d'un sujet selon l'une quelconque des revendications précédentes, lesdites données d'image provenant de plus d'un écho de signal étant mesurées dans l'intervalle entre les impulsions suivantes dans la séquence d'impulsions électromagnétiques.

6. Dispositif d'imagerie par résonance magnétique, IRM (100) qui comprend un dispositif de commande (130), le dispositif de commande étant configuré pour commander au dispositif d'IRM :
d'appliquer un champ magnétique B₀ sur un sujet ;
d'appliquer une séquence d'impulsions électromagnétiques radiofréquences sur le sujet ;
d'appliquer des gradients supplémentaires de champ magnétique en plus du champ magnétique B₀, les gradients de champ magnétique comprenant une pluralité de premiers gradients et au moins un second gradient, lesdits premiers gradients permettant la localisation de signaux à un emplacement particulier chez le sujet par une combinaison d'au moins une opération parmi la sélection de tranche, le codage de phase et le codage de fréquence, et lesdits premiers gradients étant complètement rembobinés dans l'intervalle entre les impulsions électromagnétiques radiofréquences successives, tandis que ledit au moins un second gradient présentant une intégrale temporelle non nulle entre les impulsions électromagnétiques radiofréquences successives pour assurer une modulation de signal périodique qui dépend du profil de signal hors résonance de l'aimantation chez le sujet ; et
de mesurer des échos de signal produits par le sujet en réponse à une pluralité d'impulsions électromagnétiques radiofréquences et aux premier et second gradients de champ magnétique, le dispositif de commande étant en outre configuré pour :
acquérir des données d'images de l'emplacement particulier chez le sujet à partir des échos de signal, lesdites données d'images correspondant à une série d'images à une première résolution spatiale avec différentes variations spatiales périodiques de l'aimantation résultant dudit au moins un second gradient ; et
combiner les données d'images afin de produire au moins une image du sujet à une seconde résolution spatiale, la seconde résolution spatiale étant supérieure à la première résolution spatiale,
ladite phase d'au moins une impulsion électromagnétique radiofréquence dans la séquence d'impulsions électromagnétiques radiofréquences étant différente d'une autre impulsion électromagnétique radiofréquence dans la séquence d'impulsions électromagnétiques radiofréquences,
ladite séquence d'impulsions électromagnétiques radiofréquences et de pluralité de premiers gradients de champ étant une séquence d'impulsions de précession libre d'état stationnaire,
lesdites variations spatiales périodiques de magnétisation étant générées dans l'état stationnaire ou un pseudo-état stationnaire, et contenant des informations sur les fréquences spatiales au-dessus de la fréquence de Nyquist.

7. Dispositif d'IRM (100) selon la revendication 6, ladite séquence d'impulsions électromagnétiques radiofréquences comprenant au moins un premier ensemble d'impulsions électromagnétiques radiofréquences,
une première impulsion du premier ensemble possédant une première phase φ₁, et chaque impulsion suivante du premier ensemble possédant une phase qui est incrémentée d'un premier intervalle.

8. Dispositif d'IRM (100) selon la revendication 7, ladite séquence d'impulsions électromagnétiques radiofréquences comprenant un second ensemble d'impulsions électromagnétiques radiofréquences, une première impulsion du second ensemble possédant une seconde phase φ₂, et chaque impulsion suivante dans le second ensemble possédant une phase qui est incrémentée d'un second intervalle qui est différent du premier intervalle.

9. Dispositif d'IRM (100) selon la revendication 8, ladite séquence d'impulsions électromagnétiques radiofréquences comprenant au moins un premier ensemble d'impulsions électromagnétiques radiofréquences,
une première impulsion du premier ensemble possédant une première phase φ ₁, et chaque impulsion suivante du premier ensemble possédant une phase qui est incrémentée d'un intervalle d'augmentation quadratique.

10. Dispositif d'IRM (100) selon l'une quelconque des revendications 6 à 9, lesdites données d'image provenant de plus d'un écho de signal étant mesurées dans l'intervalle entre les impulsions suivantes dans la séquence d'impulsions électromagnétiques radiofréquences.
